(19) Europäisches Patentamt
European Patent Office
Office européen des brevets

(11) **EP 3 046 147 B1**

(12) **FASCICULE DE BREVET EUROPEEN**

(45) Date de publication et mention
de la délivrance du brevet:
**25.12.2019 Bulletin 2019/52**

(51) Int Cl.:
***H01L 23/58*** *(2006.01)*     ***H01L 27/24*** *(2006.01)*

(21) Numéro de dépôt: **16151557.2**

(22) Date de dépôt: **15.01.2016**

(54) **PUCE ÉLECTRONIQUE MUNIE D'UN DISPOSITIF DE PROTECTION À MATÉRIAU À CHANGEMENT DE PHASE, PROCÉDÉ DE DÉTECTION D'UNE ATTAQUE DE LA PUCE ET PROCÉDÉ DE FABRICATION DE LADITE PUCE**

ELEKTRONISCHER CHIP, DER MIT EINER SCHUTZVORRICHTUNG MIT PHASENWECHSELMATERIAL AUSGESTATTET IST, DETEKTIONSVERFAHREN EINES ANGRIFFS AUF DEN CHIP UND HERSTELLUNGSVERFAHREN DIESES CHIPS

ELECTRONIC CHIP PROVIDED WITH A PROTECTIVE DEVICE WITH PHASE CHANGE MATERIAL, METHOD FOR DETECTING AN ATTACK ON THE CHIP AND METHOD FOR MANUFACTURING SAID CHIP

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.01.2015 FR 1550329**

(43) Date de publication de la demande:
**20.07.2016 Bulletin 2016/29**

(73) Titulaire: **COMMISSARIAT À L'ÉNERGIE ATOMIQUE ET AUX ÉNERGIES ALTERNATIVES 75015 Paris (FR)**

(72) Inventeurs:
• **LAMY, Yann**
**38960 SAINT ETIENNE DE CROSSEY (FR)**
• **PERNIOLA, Luca**
**38360 NOYAREY (FR)**

(74) Mandataire: **Brizio Delaporte, Allison et al Cabinet Hautier 20, rue de la Liberté 06000 Nice (FR)**

(56) Documents cités:
**US-A1- 2010 026 313      US-A1- 2010 301 896**
**US-A1- 2013 306 929      US-A1- 2014 376 149**
**US-B1- 8 525 169**

## Description

DOMAINE TECHNIQUE

La présente invention concerne une puce électronique munie d'un dispositif de protection à matériau à changement de phase, un procédé de détection d'une attaque de la puce et un procédé de fabrication de ladite puce.

L'invention trouvera son application dans le domaine de la sécurité et de la protection des puces électroniques. L'invention s'applique à tout type de puce électronique : puce de téléphonie mobile, carte bancaire, carte de santé, microprocesseur, interposeur (par exemple de central de calcul), microcontrôleur etc...

ETAT DE LA TECHNIQUE

Les attaques que peut subir une puce électronique ont pour but d'accéder à des données confidentielles stockées dans la puce électronique notamment pour la cloner, ou modifier les informations stockées.

Les puces électroniques peuvent être attaquées de diverses manières : chimique, physique, laser, électromagnétique, électrique...

Ces attaques sont généralement mises en oeuvre en suivant deux objectifs. Le premier consiste à acquérir ou retrouver une information interne manipulée par le circuit intégré de la puce (observation de la consommation électrique du circuit, du rayonnement électromagnétique produit par le circuit, « probing » du circuit, c'est-à-dire accéder physiquement au circuit en établissant une connexion électrique avec une piste interne du circuit, « probing » sans contact d'une piste interne, etc.). Le deuxième consiste à injecter des fautes (changement d'état d'un bit ou d'un groupe de bits via une injection de lumière, de laser, d'un rayonnement électromagnétique, etc.) pendant un calcul réalisé par le circuit intégré de la puce. Très souvent, une combinaison de ces différentes techniques est utilisée.

Pour se prémunir de telles attaques, il existe plusieurs types de protections. Le premier niveau de protection est la protection physique matérielle des puces. La face avant d'une puce électronique (face au niveau de laquelle se trouve classiquement le circuit intégré de la puce) peut par exemple être protégée en ajoutant des couches de protection particulières sur cette face avant.

Il existe également des protections de la face arrière de la puce électronique. En effet, la face arrière de la puce est une zone sensible qui peut être attaquée avec des techniques de gravure et d'amincissement actuelles permettant de s'approcher à une très faible distance du circuit intégré de la puce pour récupérer des informations stockées ou injecter des fautes dans la puce. Le document US 2010/026313 A1, par exemple, montre une puce électronique dont la face arrière est protégée.

Par ailleurs pour être efficace, il est nécessaire de pouvoir contrôler l'intégrité du dispositif de protection et détecter une attaque.

Or, les solutions proposées à ce jour ne permettent pas à la fois d'assurer une protection efficace sans risque d'altération ou de suppression du dispositif de protection et de détecter de manière fiable l'intégrité de ladite protection. Les documents US 8,525,169 B1 et US 2010/301896 A1 montrent par ailleurs des moyens de protection d'une puce électronique incluant des matériaux à changement de phase.

Il existe donc le besoin de proposer une puce électronique dont le circuit intégré est efficacement protégé et que le plus grand nombre d'attaques soit détecté de manière fiable.

RÉSUMÉ DE L'INVENTION

La présente invention propose à cet effet une puce électronique selon la revendication 1 comprenant, entre autre, un circuit intégré disposée sur une face parmi la face avant ou la face arrière d'un substrat et un dispositif de protection agencé au moins partiellement en regard du circuit intégré. Le dispositif de protection comprend au moins un condensateur comprenant une première électrode et une deuxième électrode et au moins une couche de matériau à changement de phase intercalée entre lesdites deux électrodes. La au moins une couche de matériau à changement de phase est configurée pour passer au moins localement d'un premier état résistif à un deuxième état résistif différent du premier état par pénétration d'un faisceau photonique et/ou ionique. Le premier état résistif est choisi parmi un état amorphe pour lequel le condensateur présente une première résistance et/ou une première capacité et un état cristallin pour lequel le condensateur présente une deuxième résistance et/ou une deuxième capacité. La deuxième résistance et la deuxième capacité sont respectivement différentes de la première capacité et de la première résistance. Le dispositif de protection est électriquement relié au circuit intégré de sorte que le circuit intégré détecte la résistance ou la capacité du condensateur. Cette détection permet ainsi d'identifier un changement d'état de la au moins une couche de MCP et donc détecter une attaque de la puce électronique.

L'invention permet de combiner une protection fiable du circuit intégré par un empilement protecteur comprenant une pluralité de couches et une détection fiable de toute attaque par le changement d'état d'un matériau à changement de phase contenu dans un condensateur.

Les matériaux à changement de phase sont des matériaux dans lesquels une transition résistive peut être observée. Le matériau à changement phase est configuré pour prendre alternativement un état fortement résistif, également dénommé état à haute résistance, HRS pour High Resistive State en anglais et un état faiblement résistif également dénommé état à basse résistance, LRS pour Low Resistive State en anglais. Le matériau à changement de phase est dit dans un état fortement résistif, HRS, lorsque que sa résistance est supérieure à celle du matériau dans un état faiblement résistif LRS. Classiquement, un état amorphe est un état HRS et un état cristallin est un état LRS.

Un matériau à changement de phase et les deux électrodes dans lequel le matériau à changement de phase est intercalé forment un condensateur dont les propriétés capacitives et résistives varient en fonction de l'état du matériau à changement de phase. La présence d'un condensateur agencé au moins partiellement en regard du circuit intégré, avantageusement sur une des faces de la puce électronique, présente une protection physique de la puce en augmentant l'épaisseur pour accéder au circuit intégré que ce soit par sa face avant ou par sa face arrière. Par ailleurs, un condensateur selon l'invention comprenant une couche de matériau à changement de phase assure une protection contre les attaques lasers. En effet, un faisceau ionique et/ou photonique va agir sur le matériau à changement de phase et entrainer son changement d'état avantageusement en le faisant passer d'un état HRS à LRS. Ce changement d'état est détecté par le circuit intégré auquel est relié le dispositif de protection. Préférentiellement, cette détection entraine la mise en défaut du circuit intégré.

Selon un mode de réalisation préféré, le dispositif de protection est disposé sur une face opposée au circuit intégré, préférentiellement en face arrière, face sensible de la puce électronique.

Selon l'invention, le condensateur comprend au moins trois couches de matériaux à changement de phase empilées. En effet, sous l'effet d'un faisceau photonique et/ou ionique, la chaleur reçue par la couche interne va être confinée grâce aux deux autres couches externes situées de part et d'autre de la couche interne. Ce confinement de la chaleur permet une élévation rapide de la température dans la couche de matériau à changement de phase interne, favorisant alors un changement d'état rapide. La présence de trois couches empilées permet de maintenir au moins une couche de matériau à changement de phase dans un état HRS qui soit confinée assurant une détection plus fine d'une attaque par faisceau photonique et/ou ionique.

Selon l'invention, au moins une couche prise parmi les trois couches est dans un état amorphe et au moins une autre couche parmi les trois couches est dans un état cristallin. De préférence au moins une couche amorphe est une couche interne, c'est-à-dire une couche intercalée entre deux autres couches qui sont dans un état cristallin. Ce mode de réalisation permet de rendre encore plus rapide la montée en température.

## BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les figures d'accompagnement dans lesquelles :

Figure 1 : Architecture d'un condensateur selon un mode de réalisation pour dispositif de protection selon l'invention.

Figure 2 : Vue schématique d'une puce électronique selon l'invention comprenant un circuit intégré en face avant et un dispositif de protection en face arrière soumise à une attaque laser.

Figure 3 : Vue schématique d'une puce électronique selon l'invention comprenant un circuit intégré en face avant et un dispositif de protection en face arrière soumise à une attaque par faisceau ionique focalisé (FIB Focus ion beam en anglais).

Figure 4 : Vue d'un dispositif de protection selon un autre mode de réalisation agencé sur une face d'un substrat et soumis à un faisceau laser.

Figure 5 : Vue d'un dispositif de protection selon un autre mode de réalisation agencé sur une face d'un substrat comprenant plusieurs condensateurs.

Figure 6 : Cartographie du coefficient d'absorption du rayonnement photonique de l'empilement d'un condensateur du dispositif de protection en fonction de l'épaisseur des couches externes de matériau à changement de phase.

Figure 7 : Evolution de la température maximale dans l'empilement en fonction du temps pendant une impulsion laser de 30ns et pendant les 30ns suivantes.

Figure 8 : Profil de température dans l'épaisseur du condensateur à l'issu d'une irradiation laser de 30ns, soit exactement à t=30ns.

Figure 9 : Architecture d'un condensateur selon un autre mode de réalisation de l'invention.

Les dessins joints sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

En particulier, les épaisseurs relatives des différentes couches et films ne sont pas représentatives de la réalité.

## DESCRIPTION DÉTAILLÉE DE L'INVENTION

Avant d'entamer une revue détaillée de modes de réalisation de l'invention, il est tout d'abord rappelé que l'invention concerne une puce électronique selon la revendication 1 comprenant un circuit intégré agencé sur un substrat et un dispositif de protection agencé au moins partiellement au regard du circuit intégré, le dispositif de protection comprenant au moins un condensateur comprenant :

- une première électrode,
- une deuxième électrode,
- et au moins trois couches empilées de matériaux à changement de phase, définissant au moins deux couches externes et au moins une couche interne intercalée entre lesdites au moins deux couches externes,

en ce que lesdites au moins trois couches empilées de matériaux à changement de phase sont disposées au moins partiellement entre les deux électrodes, en ce qu'au moins une première couche prise parmi lesdites au moins deux couches externes et ladite au moins une couche interne est dans un état amorphe et est configurée pour passer au moins localement par pénétration d'un faisceau photonique et/ou ionique dudit état amorphe pour lequel le condensateur présente une première capacité et/ou une première résistance à un état cristallin pour lequel le condensateur présente une deuxième capacité et/ou une deuxième résistance respectivement différentes de la première capacité et de la première résistance, et en ce que au moins une deuxième couche prise parmi lesdites au moins deux couches externes et ladite au moins une couche interne est dans un état cristallin, le dispositif de protection étant relié électriquement au circuit intégré par au moins une desdites première ou deuxième électrodes de sorte que le circuit intégré mesure la résistance et/ou la capacité du condensateur.

Sont énoncées ci-après des caractéristiques optionnelles alternatives ou cumulatives qui peuvent éventuellement être utilisées en association avec les caractéristiques de la revendication 1 :

- la deuxième résistance du condensateur est inférieure à la première résistance ;
- le circuit intégré est agencé sur une première face parmi une face avant ou une face arrière du substrat et dans lequel le dispositif de protection est agencé sur une deuxième face du substrat, différente de la première face sur laquelle le circuit intégré est agencé et choisie parmi la face avant ou la face arrière du substrat ;
- chacune des premières et deuxième électrodes recouvrent respectivement et entièrement l'une des deux couches externes.
- les premières et deuxième électrodes recouvrent partiellement au moins et respectivement une couche externe qui lui est associée et au moins l'une parmi les premières et deuxième électrodes recouvrent une partie seulement de la couche externe qui lui est associée.
- au moins une couche interne est ladite première couche dans un état amorphe et au moins l'une desdites deux couches externes est ladite deuxième couche dans un état cristallin.la puce comprend une couche interne formant ladite première couche dans un état amorphe et deux couches externes dans un état cristallin.
- le dispositif de protection comprend au moins trois couches empilées de matériaux à changement de phase définissant deux couches externes et au moins une couche interne.

- les deux couches externes sont dans un état cristallin et la au moins une couche interne est dans un état amorphe ;
- la température de cristallisation de la au moins une couche interne de matériau à changement de phase est supérieure aux températures de cristallisation des couches externes de matériau à changement de phase ;
- les couches externes de matériau à changement de phase ont une épaisseur comprise entre 50nm et 200nm ;
- la au moins une couche interne de matériau à changement de phase a une épaisseur de préférence comprise entre 5 et 30nm ;
- le circuit de protection est relié électriquement au circuit intégré par une interconnexion enterrée ;
- le circuit intégré agencé sur une face parmi une face avant ou une face arrière du substrat et dans lequel le dispositif de protection s'étend sur une surface du substrat au moins équivalente à la surface sur laquelle s'étend le circuit intégré ;
- le au moins un condensateur comprend au moins une tranchée formée dans l'épaisseur du substrat ;
- la tranchée présente une largeur de préférence comprise entre 500nm à 1$\mu$m ;
- le dispositif de protection comprend une pluralité de condensateurs connectés en série.

Selon un autre aspect, l'invention concerne aussi un procédé de fabrication d'une puce électronique telle que décrite ci-dessus caractérisé en ce qu'il comprend les étapes suivantes de :

- formation d'un circuit intégré au niveau d'une face d'un substrat choisie parmi la face avant ou la face arrière ;
- formation d'au moins un condensateur au moins partiellement au regard du circuit intégré comprenant

  ∘ le dépôt d'une première électrode,
  ∘ la formation d'au moins une première couche externe en matériau à changement de phase, située au moins partiellement au regard de la première électrode,
  ∘ la formation d'au moins une couche interne en matériau à changement de phase, configurée pour passer au moins localement d'un état amorphe à état cristallin par pénétration d'un faisceau photonique et/ou ionique, le condensateur présentant dans l'état amorphe de l'au moins une couche interne une première capacité et/ou une première résistance et le condensateur présentant dans l'état cristallin de l'au moins une couche interne une deuxième capacité et/ou une deuxième résistance respectivement différentes de la première capacité et de la première résistance,

○ la formation d'au moins une deuxième couche externe en matériau à changement de phase, au moins l'une parmi ladite première et ladite deuxième couches externes étant dans un état cristallin;

○ et le dépôt d'une deuxième électrode au moins partiellement en regard de la deuxième couche externe ;

- connexion électrique du circuit de protection au circuit intégré.

Avantageusement l'étape de formation de l'au moins une première couche externe ou l'étape de formation de l'au moins une deuxième couche externe comprend le dépôt d'une couche de matériau à changement de phase dans un état amorphe.

Avantageusement, les étapes postérieures au dépôt de la au moins une couche interne sont configurées de sorte à maintenir le premier état de la au moins une couche interne de matériau à changement de phase.

Avantageusement, le procédé de fabrication comprend une étape postérieure au dépôt d'au moins une couche interne configuré de sorte à faire passer le matériau à changement de phase d'au moins une des deux couches externes d'un premier état à un deuxième état différent du premier état.

Avantageusement, le procédé de fabrication est configuré de sorte à faire passer le matériau à changement de phase d'au moins une des deux couches externes de l'état amorphe à un état cristallin.

Il est précisé que dans le cadre de la présente invention, le terme « sur », « surmonte » ou « sous-jacent » ou leurs équivalents ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Il est établit que la capacité électrique d'un condensateur se détermine essentiellement en fonction de la géométrie des électrodes et de la nature du ou des isolants ; la formule simplifiée suivante est souvent utilisée pour estimer sa valeur :

$$C = \varepsilon \frac{S}{e} \qquad \text{Formule I}$$

Avec S : surface des électrodes en regard, e : distance entre les électrodes et ε la permittivité du diélectrique.

Dans le cadre de la présente invention, le diélectrique est le matériau à changement de phase (MCP) dont la résistance dépend de son état.

La puce électronique selon l'invention comprend un substrat 2 sur lequel, préférentiellement sur sa face avant 4, est disposé un circuit électronique préférentiellement un circuit intégré 1. Le circuit intégré 1 peut être divers, par exemple un semi-conducteur complémentaire à l'oxyde de métal (CMOS: Complementary Metal Oxide Semiconductor en anglais) peut être utilisé. Le substrat 2 peut comprend plusieurs circuits intégrés 1 protégés ou non par un même ou plusieurs dispositif de protection 3 décrit ci-après.

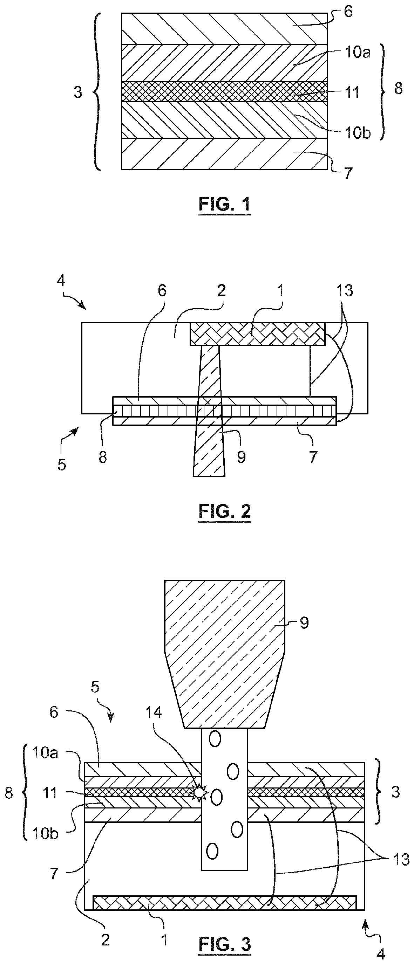

Selon l'invention, la puce électronique comprend un dispositif de protection 3 agencé au moins partiellement en regard du circuit intégré 1, avantageusement sur une des faces avant ou arrière du substrat 2. Dans le cas d'un agencement en face avant, le dispositif de protection peut être formé directement au-dessus du circuit intégré 1. Le dispositif de protection peut également être enterré dans le substrat, ou être formé sur un autre substrat agencé au moins partiellement en regard du circuit intégré 1, tel que par exemple un capot de protection du circuit intégré 1. Le dispositif de protection 3 est disposé au moins partiellement en regard du circuit intégré 1 et, avantageusement pour assurer une protection optimale, le dispositif de protection 3 s'étend sur une surface du substrat 2 supérieure à la surface du circuit intégré 1 tel qu'illustré en figure 2.

Selon un mode de réalisation préféré, le dispositif de protection 3 est placé sur la face du substrat 2 opposée à la face recevant le circuit intégré 1. Préférentiellement, le dispositif de protection 3 est en face arrière 5 et le circuit intégré 1 est en face avant 4 du substrat 2.

Le dispositif de protection 3 comprend un condensateur. Le condensateur comprend une première électrode 6, également appelée « top electrode » pour électrode supérieure et une deuxième électrode 7, également appelée « bottom electrode » pour électrode inférieure. Le condensateur comprend entre la première électrode 6 et la deuxième électrode 7, au moins une couche de MCP 8. Le condensateur est un empilement de couches comprenant au moins les deux électrodes 6, 7 et au moins une couche de MCP 8 intercalée.

Le dispositif de protection 3 est relié électriquement au circuit intégré 1, préférentiellement par au moins une des deux électrodes 6, 7. Selon une possibilité, le dispositif de protection 3 est relié par une électrode 6, 7 au circuit intégré 1 et est connecté à une masse de référence par l'autre desdites électrodes, 6, 7. Cette masse peut être extérieure au circuit intégré 1. Selon une autre possibilité préférée, les deux électrodes 6, 7 sont reliées électriquement au circuit intégré 1.

Dans le cas où le dispositif de protection 3 est agencé sur une même face que le circuit intégré 1 les connexions électriques sont des connexions standards en microélectroniques composées de lignes conductrices horizontales (e.g. cuivre) et de connexions verticales (vias en anglais). Dans le cas où le dispositif de protection 3 est agencée sur une face opposée au circuit intégré 1, les connexions électriques sont des interconnexions verticales dites également enterrées à travers le substrat 2, par exemple par des tranchées à travers le silicon (Through Silicon Vias -TVS en anglais).

La connexion électrique du condensateur directement sur le circuit intégré 1 permet une mesure de la capacité et/ou de la résistance du condensateur et de ce fait permet la détection d'une attaque par faisceau ionique et/ou photonique 9. Grâce à l'invention, le circuit intégré 1 mesure avantageusement en continu la capacité et/ou de la résistance du condensateur ce qui implique que le contrôle de l'état du MCP est continu et donc la détection d'une attaque est permanente.

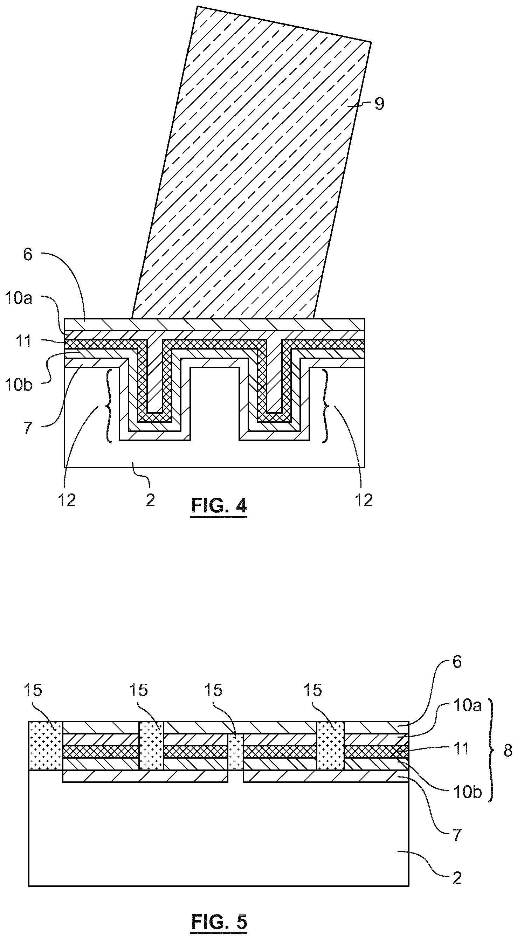

La suite de la description est faite pour un condensateur du dispositif de protection 3. Le dispositif de protection peut comprendre plusieurs condensateurs tels que décrit ci-après et illustré en figure 5.

Le condensateur selon l'invention comprend au moins une couche de MCP 8. Le MCP 8 est préférentiellement dans un premier état avant toute attaque par faisceau photonique et/ou ionique. La pénétration d'un faisceau photonique et/ou ionique 9 au travers de la au moins une couche de MCP 8 entraine le changement d'état dudit MCP 8 vers un deuxième état. Le premier état et le deuxième état sont des états différents et avantageusement, le premier état et le deuxième état présentent des résistances différentes. La résistance différente du MCP 8 entre le premier état et le deuxième état implique aussi une capacité et/ou une résistance différente du condensateur en fonction de l'état du MCP 8.

Le premier état et le deuxième état sont choisis parmi un état fortement résistif, également dénommé état à haute résistance, HRS pour High Resistive State en anglais et un état faiblement résistif également dénommé état à basse résistance, LRS pour Low Resistive State en anglais. Le matériau à changement de phase est dit dans un état fortement résistif, HRS, lorsque que sa résistance est supérieure à celle du matériau dans un état faiblement résistif LRS. Préférentiellement, l'état fortement résistif ou HRS est également dénommé état amorphe et l'état faiblement résistif ou LRS est également dénommé état cristallin.

Selon un mode de réalisation préféré, le premier état de la au moins une couche de MCP 8 est un état fortement résistif HRS, état amorphe pour lequel le condensateur présente une première capacité et/ou une première résistance et le deuxième état est un état faiblement résistif LRS, état cristallin, pour lequel le condensateur présente une deuxième capacité et/ou une deuxième résistance. De cette manière, le changement d'état du MCP 8 implique un changement de résistance et/ou de capacité du condensateur qui est détecté par le circuit intégré 1. Avantageusement, la deuxième résistance du condensateur est inférieure à la première résistance du condensateur. La première capacité du condensateur est constante pour le premier état de la au moins une couche de MCP 8. La deuxième capacité du condensateur est variable pour le deuxième état de la au moins une couche de MCP 8 notamment en fonction du changement d'état partiel ou total de la au moins une couche de MCP 8 et du nombre de couches de MCP 8. La deuxième capacité peut être inférieure ou bien supérieure à la première capacité.

Le circuit intégré 1 relié électriquement au condensateur peut surveiller un changement de capacité et/ou de résistance dudit condensateur.

La pénétration du faisceau ionique et/ou photonique 9 dans la au moins une couche de MCP 8 entraine une augmentation au moins locale de la température. C'est cette augmentation de température qui va déclencher le passage du premier état au deuxième état du MCP.

On entend par faisceau photonique et/ou ionique 9, un faisceau laser ou faisceau ionique dit FIB (Focus Ion Beam). Les faisceaux photonique de type laser classiquement utilisés pour les attaques de puces électroniques ont une longueur d'onde de 40nm à 1500nm. L'attaque par faisceau ionique, FIB, bien qu'étant considérée comme une attaque destructrice de la puce électronique, il peut être extrêmement localisé avec des trous de quelques microns. Cette destruction localisée n'entraine qu'une faible modification de la puce électronique qui n'est pas facilement identifiable. Toutefois, le dispositif de protection 3 selon l'invention est également sensible à ce type d'attaque qui génère un échauffement 14 au niveau de la zone de destruction, comme illustrée en figure 3. Cet échauffement 14 localisé entraine un changement d'état de la couche à MCP 8 du condensateur du dispositif de protection 3. Le passage à l'état cristallisé d'au moins une couche de MCP 8, localement au niveau des parois de la zone de destruction entraine un changement de la capacité et/ou de la résistance du condensateur qui est détecté par le circuit intégré 1.

Le passage du premier état au deuxième état du MCP peut être uniquement local dans la couche de MCP 8. C'est-à-dire qu'il n'est pas nécessaire que la totalité de la couche de MCP 8 passe du premier état au deuxième état. Avantageusement, un changement local suffisant pour impliquer un changement de la résistance du MCP et donc de la capacité et/ou de la résistance du condensateur qui est détecté par le circuit intégré 1.

Avantageusement, le condensateur comprend au moins trois couches de MCP empilées entre les deux électrodes 6, 7. De manière préférentielle et non limitative, le condensateur comprend trois couches de MCP empilées entre les deux électrodes 6,7. Cette disposition permet de proposer un dispositif de protection 3 plus sensible au faisceau photonique et/ou ionique 9. L'empilement définit deux couches de MCP 10a, 10b externes. Entre les deux couches externes 10a, 10b, l'empilement comprend au moins une couche interne 11 de MCP. Selon le mode de réalisation non limitatif illustré sur les figures, l'empilement comprend une seule couche interne 11. Cela permet de faciliter la réalisation et de réduire le cout de la puce. Les deux couches externes 10a, 10b ont une action de concentration de chaleur lors de l'attaque par faisceau ionique et/ou photonique 9 favorisant de manière très importante l'élévation de la température dans la couche interne 11. Le passage du premier état au deuxième état est donc accéléré pour la couche interne permettant une détection même en cas d'attaque de courte durée. Pour obtenir une détection d'attaque par faisceau ionique et/ou photonique 9 optimale, il est préféré que le condensateur comprenne plusieurs couches de MCP. L'empilement de trois couches de MCP est un mode de réalisation privilégié.

Dans une réalisation alternative de l'invention, le dispositif de protection 3 comprend un empilement de plus de trois couches. Dans cette réalisation, le dispositif de protection 3 comprend au moins une couche interne 11 dans un état différent des couches externes 10a 10b. On entend par couche interne 11 une couche comprise entre au moins deux autres couches. Ces deux autres couches peuvent avantageusement être des couches externes 10a 10b au contact d'une électrode 6, 7. Dans un exemple non limitatif comprenant 5 couches, on retrouve deux couches externes 10a et 10b délimitant les surfaces supérieure et inférieure de l'empilement, et trois couches comprise entre ces couches externes 10a 10b. Ces trois couches sont des couches internes 11. Elles sont en effet toutes comprises entre deux autres couches (soit entre l'une des couches externes 10a ou 10b et une autre couche interne 11, soit entre deux couches internes 11). Les couches externes 10a 10b sont avantageusement en contact respectivement avec la première électrode 6 et la deuxième électrode 7.

De manière particulièrement avantageuse et comme sera détaillé par la suite, au moins l'une des couches externes 10a, 10b ou interne(s) 11 est dans un état amorphe et au moins une autre de ces couches est dans un état cristallin. De préférence la ou au moins l'une des couches internes 11 est amorphe. Selon un mode de réalisation particulièrement avantageux, la ou au moins l'une des couches internes 11 est amorphe et les deux couches externes 10a, 10b sont cristallines. Cela permet de confiner la zone de montée en température et de détecter de manière particulièrement rapide et fine une attaque.

De préférence les couches cristallines sont formées par dépôt d'une couche amorphe puis par une opération de cristallisation de cette couche.

Chaque couche externe 10a, 10b est au contact de l'une des deux électrodes 6,7 par une face externe de la couche externe 10a, 10b tournée au regard de cette électrode.

Selon un mode de réalisation la surface de contact entre la couche externe 10a, 10b et l'électrode 6,7 qui lui est associé est égale à la surface de face externe de cette couche externe 10a, 10b. Autrement dit l'électrode 6,7 recouvre entièrement la couche externe 10a, 10b.

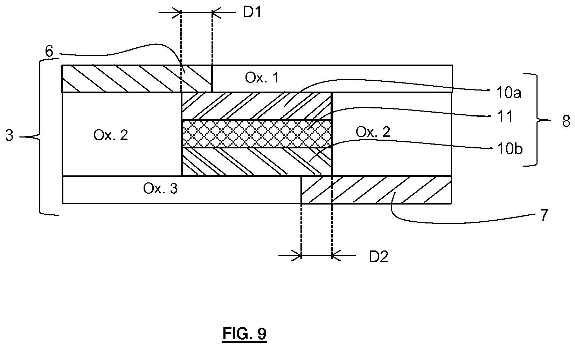

Selon un mode de réalisation, l'électrode 6,7 recouvre une partie seulement de la couche externe 10a, 10b. Ainsi la surface de contact entre la couche externe 10a, 10b et l'électrode 6,7 qui lui est associé est inférieure à la surface de face externe de cette couche externe 10a, 10b. Ce mode de réalisation est illustré en figure 9. sur cet exemple les électrodes 6, sont en contact avec les couches externe 10a 10b uniquement sur une distance D1 et D2, prise selon une dimension (horizontale sur la figure 9), correspondant à une portion seulement des couches externes 10a, 10b prise selon cette même dimension. A titre d'exemple D1 et D2 peuvent être comprise entre de 1 à 100 nm. Une portion plus grande de contact est aussi envisageable.

Ainsi, dans une réalisation de l'invention, les électrodes 6,7 sont avantageusement décalées par rapport à la ou aux couches de MCP. Dans cette hypothèse les éléments d'électrodes positionnés sont avantageusement reliés électriquement en série.

Ce décalage de superposition entre électrodes 6, 7 et couches de MCP 10a, 10b, 11, permet une meilleure sensibilité aux attaques pour un condensateur avec au moins trois couches de MCP 8 grâce à l'éloignement des drains thermiques que sont les électrodes métalliques. La capacité de détection d'une attaque par le dispositif est ainsi augmentée. Un autre avantage de cette architecture spécifique est une diminution des contraintes et une réduction de la flèche (en anglais wrap/bow) de l'empilement. Notamment la combinaison, au sein d'un même empilement, de couches conductrices formant les électrodes et de couches de MCP, entraine des contraintes et une certaine flèche. La réduction de la surface des électrodes permet de réduire ces phénomènes.

Avantageusement, la couche interne 11 est dans un premier état, HRS, amorphe. Cette couche interne 11 est donc enfoui dans l'empilement de couches de MCP 8.Les deux couches externes 10a, 10b sont préférentiellement dans un deuxième état, LRS, cristallin. Dans une réalisation alternative, au moins l'une des couches externes 10a 10b est dans un état cristallin. De cette manière, ces deux couches externes 10a, 10b jouent le rôle de tampon face à la dissipation de chaleur hors de la couche interne 11. Les deux couches externes 10a, 10b dans leur état cristallin jouent un rôle d'isolant thermique de la couche interne 11, sans pour autant limiter le seuil de détection de l'attaque par faisceau ionique ou photonique 9. La chaleur reçue par la couche interne 11 lors de l'attaque est maintenue dans celle-ci.

Dans une réalisation comprenant plusieurs couches internes 11 (réalisation comprenant plus de trois couches MCP 8), au moins une des couches internes 11 est dans un état amorphe. Les autres couches internes 11 peuvent avantageusement être dans un état amorphe ou cristallin. Dans une réalisation avantageuse de l'invention, une seule couche interne 11 est présente entre deux couches externes 10a 10b. Dans cette configuration la couche interne 11 est dans un état amorphe, et les couches externes 10a, 10b dans un état cristallin.

Selon un mode de réalisation préféré, le couche interne 11, ou la au moins une couche de MCP 8 dans le cas d'une seule couche de MCP 8 dans le condensateur, est dans un premier état dit état originel. Préférentiellement, le premier état est l'état HRS, amorphe. On entend par originel, l'état obtenu à l'issu de l'étape de dépôt de ladite couche et avant toute autre étape ultérieure de fabrication ou de programmation ou de changement d'état. Dans l'état originel, la valeur de la capacité et/ou de la résistance est dite initiale.

Dans le cas de l'empilement de trois couches de MCP, il est préféré que la température de cristallisation du MCP de la couche interne 11 soit supérieure à la température de cristallisation du ou des MCP des couches externes 10a, 10b.

Formulé différent, il est préféré que le budget thermique des étapes de fabrication de la puce électronique postérieures à l'étape de dépôt de la couche interne 11 soit inférieur à la température de cristallisation du MCP de la couche interne 11.

La couche interne 11 a préférentiellement une épaisseur comprise entre 5 et 30 nm, préférentiellement 10nm.

L'épaisseur de la couche interne 11 est définit pour être suffisamment épaisse pour assurer une isolation électrique dans son état amorphe et suffisamment fine pour permettre la formation d'une voie conductrice lorsque du passage à un état cristallin.

Les couches externes 10a, 10b ont une épaisseur suffisante pour éviter un refroidissement rapide de la couche interne 11 en contact pouvant entrainer des modifications inopiné d'état du MCP d'un état cristallin à un état amorphe. Par exemple, une épaisseur inférieure ou égale à 200nm est préférée. Par ailleurs, l'épaisseur des couches internes 10a, 10b doit être suffisante pour jouer le rôle d'isolant thermique entre la couche interne 11 et les électrodes 6, 7. Par exemple, l'épaisseur est supérieure ou égale à 50nm.

Le MCP pouvant être utilisé pour former la au moins une couche de MCP 8 est le GST : $Ge_xSb_yTe$. Ce type de MCP est particulièrement sensible à l'échauffement généré par un faisceau ionique et/ou photonique. Il peut être aisément déposé par dépôt en phase vapeur (PVD pour Physical Vapor Déposition) ou par dépôt chimique en phase vapeur assisté par plasma (PECVD, pour Plasma-Enhanced Chemical Vapor Déposition), à différentes températures, ce qui est très utile pour le procédé de fabrication de l'invention décrit ci-après.

Pour régler la conductivité thermique Kth, le volume de chaleur spécifique Cv ou la température de cristallisation, des dopants peuvent être introduits dans le MCP tels que l'oxygène, l'azote, l'indium, le cérium. Le dopage du MCP influence notamment la température de cristallisation. Par exemple, la température de cristallisation du GeTe dopé au carbone varie de 170°C pour 0% de carbone à plus de 400°C pour 24% de carbone. Dans le cas de GST dopé au carbone la température de cristallisation varie de 150°C pour 0% de carbone à plus de 340°C pour 24% de carbone. Dans le cas de GeTe dopé à l'azote, la température de cristallisation varie de 170°C pour 0% d'azote à plus de 270°C pour 10% d'azote. Ces variations de température de cristallisation ne sont pas suivies par les mêmes variations de la température de fusion. Par exemple, GeTe et GeTe dopé à 10% d'azote présente sensiblement la même température de fusion autour de 715°C.

L'invention concerne selon un aspect, un procédé de fabrication d'une puce électronique telle que décrite, plus précisément le procédé de fabrication du dispositif de protection sur une puce électronique munie sur une face d'au moins un circuit intégré 1. Sur un substrat au moins un circuit intégré 1 est tout d'abord formé.

Le procédé comprend les étapes suivantes :

- Dépôt, par exemple par dépôt en phase vapeur (PVD pour Physical Vapor Déposition) de la première électrode 6, par exemple en aluminium, électrode transparente en oxyde d'étain indium (ITO pour Indium Tin Oxide).
- Dépôt d'au moins une couche de MCP 8, par exemple dépôt successif de trois couches dont deux externes 10a, 10b, et une interne, 11, par exemple par dépôt en phase vapeur (PVD pour Physical Vapor Déposition) ou par dépôt chimique en phase vapeur assisté par plasma (PECVD, pour Plasma-Enhanced Chemical Vapor Déposition). Avantageusement, on dépose en premier lieu une première couche externe 10a au moins partiellement en contact avec la première électrode 6. On dépose ensuite la couche interne 11, et enfin on dépose la deuxième couche externe 10b. Dans une réalisation de l'invention, la couche externe 10a est déposée pour être totalement en contact avec la première électrode 6.
- Dépôt de la première électrode 7, au moins partiellement en contact avec la couche externe 10b, par exemple en aluminium, électrode transparente en oxyde d'étain indium (ITO pour Indium Tin Oxide), par exemple par dépôt en phase vapeur (PVD pour Physical Vapor Deposit) ou par dépôt chimique en phase vapeur assisté par plasma (PECVD, pour Plasma-Enhanced Chemical Vapor Déposition).

Dans une réalisation alternative de l'invention, la deuxième électrode 7 est déposé en premier, viens ensuite la couche externe 10b, la couche interne 11, la couche externe 10a et enfin la première électrode 6. Comme dans la première réalisation, le contact entre les électrodes 6,7 et les couches externes 10a 10b peut être partiel ou total.

A titre d'exemple, la première électrode 6 et la deuxième électrode 7 sont en aluminium d'une épaisseur respective de 50nm et la couche interne 11 est d'une épaisseur de 10nm.

L'étape de dépôt de la première électrode 6 est effectué à une température inférieure à la température de cristallisation de la au moins une couche de MCP 8, plus précisément inférieure à la température de cristallisation du MCP de la couche interne 11.

Selon un mode de réalisation, le procédé comprend une étape de recuit après le dépôt des au moins trois couches de MCP 10a, 10b, 11. Cette étape de recuit est réalisée à une température supérieure à la température de cristallisation du ou des MCP des couches externes 10a, 10b mais à une température inférieure à la température de cristallisation du MCP de la couche interne 11. De cette manière, les couches externes 10a, 10b vont être dans un état de cristallisation tandis que la couche interne 11 restera dans un état originel, préférentiellement un état amorphe.

Il est avantageux que les propriétés du dispositif de protection et plus spécifiquement du condensateur soient optimisées pour obtenir une probabilité de détection de n'importe quelle attaque par faisceau ionique et/ou photonique 9 la plus haute possible.

Les paramètres non exhaustifs impliqués dans l'optimisation du condensateur sont d'une part les paramètres des matériaux de chaque couches de l'empilement formant le condensateur incluant les électrodes 6, 7 : par exemple l'index de réfraction n, l'index d'absorption k, la conductivité thermique Kth, le volume de chaleur spécifique Cv, l'épaisseur t. La valeur de ces paramètres sont intrinsèques aux matériaux choisis et sont connus pour chacun dans la littérature et d'autre part, les propriétés du faisceau photonique et/ou ionique 9 utilisé pour attaquer la puce électronique : longueur d'onde $\lambda$, puissance Pw, dimension du faisceau au point de contact d, la durée de la pulsation laser $t_{pulse}$, la durée entre chaque pulsation $t_{idle}$.

À partir de telles informations, l'absorbance des couches de MPC peut être maximisée et par conséquent également le profil thermique à l'intérieur du condensateur pendant le tir laser. Afin d'assurer qu'un chemin de percolation cristallin est créé à l'intérieur de la couche interne 11 de MPC, la température doit s'élever localement au-dessus de la température de cristallisation de la couche interne 11 de MCP, de sorte que la cristallisation se déclenche.

Exemple :

Un exemple d'optimisation quantitative du condensateur illustré en figure 1 est réalisée comme suit. Dans les paramètres microscopiques suivants (lorsqu'ils ne sont pas définis ailleurs) sont ceux du GST (alliage de germanium, antimoine et tellure dans une proportion 225, Ge2Sb2Te5). Les couches externes de MCP 10a, 10b se composent de GST standard possédant une température de cristallisation Tc de l'ordre de 150 °C, permettant de les retrouver à l'état cristallin à la fin du procédé de fabrication. La couche interne de MCP se compose d'une version carbone dopé de GST, plus précisément GST-C15%, qui permet d'augmenter la température de cristallisation Tc ~ 150 °C du GST à Tc ~ 325 °C pour le GST-C15%, sans modifier sensiblement les autres paramètres tels que l'indice de réfraction n (= 3,8) et l'indice d'absorption k (= 3,4), afin d'assurer son intégrité amorphe à la fin du procédé de fabrication. La conductivité thermique Kth et le volume de chaleur spécifique Cv sont identiques pour le MCP des couches interne 11 et externes 10a, 10b dans l'état amorphe et dans l'état cristallin (Kth = 0,3 W/m*K; Cv = 1.3e6 J/m$^3$*K).

Les étapes pour optimiser l'empilement sont décrites ci-après :

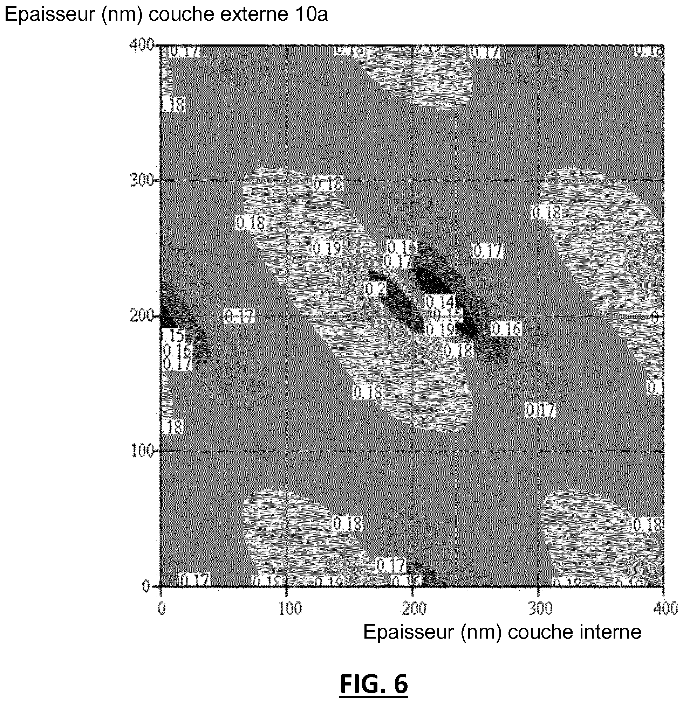

1. Maximiser l'absorption de l'empilement afin de convertir le plus rapidement possible toute attaque par faisceau ionique et/ou photonique 9 en un chauffage thermique, afin de provoquer la cristallisation de la au moins une couche de MCP 8, plus précisément de la couche interne 11 de MCP. A partir de n, k, Ke, $\lambda$ = 1000 nm (longueur d'onde généralement utilisée pour les attaques), calculer les dimensions des couches externes 10a, 10b, notamment l'épaisseur afin d'avoir une absorbance maximale. En Figure 6, un maximum local est obtenu pour $t_{couche\ externe\ 10a}$ = 200 nm et $t_{couche\ externe\ 10b}$ 200 nm. ($t_{couche\ interne\ 11}$ = 10 nm est constante). Ce ne sont pas les seules possibilités, car à partir de la carte de la figure 6, on en déduit d'autres maxima qui peuvent être utilisés aussi, par exemple $t_{couche\ externe\ 10a}$ = 400 nm et $t_{couche\ externe\ 10b}$ = 200 nm. ($t_{couche\ interne\ 11}$ = 10 nm est constante). Il est préférable d'éviter les maxima qui relèvent t = 0 nm pour l'autre couche qui impliquerait une mauvaise isolation thermique vis-à-vis des électrodes 6, 7 et donc une diminution de la fiabilité de la détection des attaques.

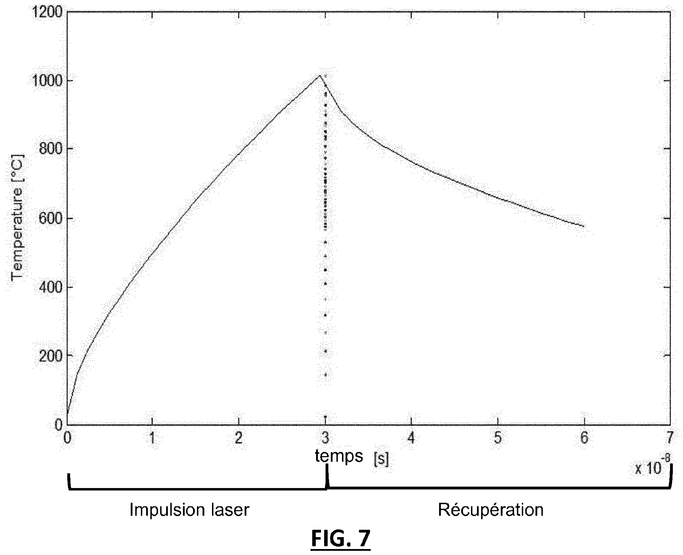

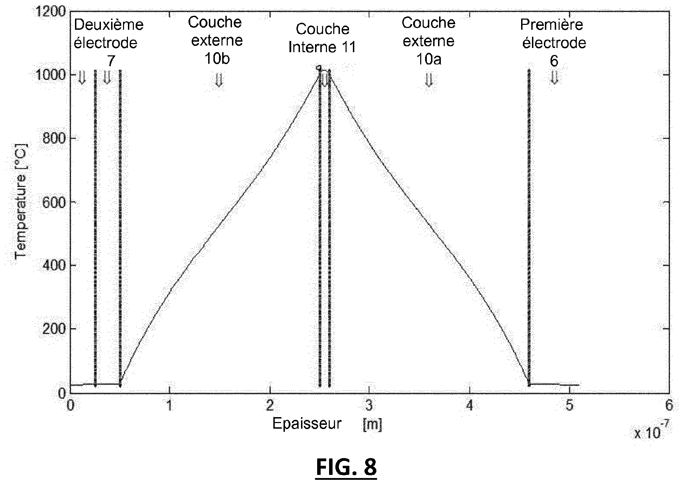

2. Calculer la répartition de la température à l'intérieur de l'empilement avec tous les paramètres concernant les matériaux et le laser avec d = 2 pm, Pw = 250 mW, $T_{pulse}$ = 30 ns, $T_{idle}$ = 30 ns, on obtient les graphes des figures 7 et 8. Afin d'être sûr que l'attaque laser soit détectée, la couche interne 11 dans l'état amorphe doit cristalliser. Il faut donc que la température à l'intérieur de la couche interne 11 soit supérieure à la température de cristallisation du MCP de cette couche. Si par exemple le $Tc_{couche\ interne\ 11}$ ~ 400°C, la cristallisation débute après 10 ns de pulsation laser. Nous notons par ailleurs qu'il est impossible d'avoir une transition cristalline à amorphe parasite dans ladite couche interne 11 lors des phases intermédiaires (notés « récupération » en figure 7) entre les pulsations laser, parce que la vitesse de refroidissement du MCP est très lente par rapport à la vitesse nécessaire pour la transition vers l'état amorphe, habituellement supérieure à 1e10 K/ sec).

Suivant des variantes possibles, le condensateur possède une structure 3D. Des tranchées 12 sont formées dans le substrat 2. Les tranchées 12 sont réalisées par des techniques de gravures classiques. L'empilement du condensateur est ensuite déposé dans les tranchées 12. Chaque tranchée 12 reçoit la deuxième électrode 7, la au moins une couche de MCP 8 et la première électrode 6. Préférentiellement, la au moins une couche de MCP 8 vient combler la tranchée et rétablir un plan sur lequel est déposé la première électrode 6. Une telle structure est illustrée en figure 4 avec trois couches de MCP 10a, 10b, 11. Préférentiellement, une tranchée présente une dimension en largeur de 500nm à 1μm. De cette manière, un faisceau laser classique d'un diamètre au point de contact de l'ordre de 1 à 2μm touchera au moins une tranchée 12.

Cette structure en tranchée du condensateur du dispositif de protection 3 augmente le volume traversé de MCP à l'état amorphe de la couche interne 11 et de MCP des couches externes 10a, 10b qui reçoit le faisceau ionique et/ou photonique 9. La chaleur générée dans les MCP est donc augmentée définissant une sensibilité accrue au dispositif de protection 3 même pour des attaques à faible puissance.

Suivant une autre possibilité, le dispositif de protection 3 comprend une pluralité de condensateurs en série. Pour obtenir cette structure, plusieurs condensateurs tels que décrits précédemment sont agencées sur une face du substrat 2 et sont connectés en série. Un exemple de structure est illustré en figure 5. Des ilots d'isolant 15 sont déposés entre les condensateurs de manière à assurer une connexion en série. Sur la figure 5, les condensateurs sont identiques, toutefois, il peut être prévu un dispositif de protection avec des condensateurs différents. Selon cette possibilité, c'est la capacité et/ou la résistance totale du dispositif de protection 3 qui est surveillée. L'inverse de la capacité totale est calculé par la formule suivante où $C_1$ correspond à la capacité de la première structure $C_2$, ... $C_N$ les capacités de la deuxième ou n-ième structure

$$1/Ctotal = \sum_{i=1}^{N}(1/C_i)$$

Lors d'une attaque par faisceau ionique et/ou photonique 9, il suffit qu'une couche interne 11 de MCP passe à l'état cristallin pour faire changer la capacité et/ou de la résistance totale du dispositif de protection 3 par rapport à son état initial. Cette modification de la capacité et/ou de la résistance totale est détecté par le circuit intégré 1.

Selon une possibilité, la couche interne de MCP 11 de certains condensateurs connectés en série peut être à l'état cristallin.

Nous décrivons ci-après un procédé de détection d'attaque par faisceau photonique et/ou ionique 9 d'une puce électronique telle que décrite ci-dessus.

Chaque dispositif de protection 3 possède une capacité dite de référence (RCV pour Reference Capacitance Value) ou RRV (pour Reference Résistance Value). Ci-dessous on prendra l'exemple de la RCV, mais il peut être transposé à l'identique pour la RRV. Cette RCV doit être maintenue durant toute la durée de vie de la puce électronique. Un changement de valeur de la capacité doit être détectée par le circuit intégré 1 comme le signal d'une attaque.

Préférentiellement, le circuit intégré 1 identifie lui-même la RCV qui doit être maintenue durant toute la durée de vie de la puce électronique. Cette RCV correspond à la capacité initiale du dispositif de protection 3. Elle est avantageusement mesurée à la mise en service de la puce électronique. Selon un autre mode de réalisation, la RCV est une donnée écrite dans la puce électronique lors de sa fabrication. Le circuit intégré 1 récupère cette donnée lors de la mise en service de la puce électronique. Il est préféré de mesurer de la capacité initiale plutôt que d'avoir un codage initial car cela évite qu'il y ait une attaque pour la récupération de cette donnée RCV ou son imposition pour déjouer la détection de l'attaque.

Au cours de la vie de la puce électronique, le circuit intégré 1 effectue des mesures ultérieures de la capacité du dispositif de protection 3. La puce électronique effectuée une comparaison de la valeur ultérieure de la capacité avec la capacité initiale RCV. L'identification d'une différence signale l'existence d'une attaque par faisceau photonique et/ou ionique 9. Avantageusement, la puce électronique se met immédiatement en défaut de sorte à empêcher la réussite de l'attaque et permettre d'informer l'utilisateur de l'existence d'une attaque.

REFERENCES

1. Circuit intégré
2. Substrat
3. Dispositif de protection
4. Face avant du substrat
5. Face arrière du substrat
6. Première électrode
7. Deuxième électrode
8. Couche matériau à changement de phase
9. Faisceau ionique et/ou photonique
10a. Couche externe de matériau à changement de phase
10b. Couche externe de matériau à changement de phase
11. Couche interne de matériau à changement de phase
12. Tranchées
13. Connexion électrique
14. Echauffement
15. Isolant

**Revendications**

1. Puce électronique comprenant un circuit intégré (1) agencé sur un substrat (2) et un dispositif de protection (3) agencé au moins partiellement au regard du circuit intégré (1), la puce électronique étant de telle sorte que le dispositif de protection (3) comprend au moins un condensateur comprenant :

- une première électrode (6),
- une deuxième électrode (7),
- et au moins trois couches (10a, 10b, 11) empilées de matériaux à changement de phase, définissant au moins deux couches externes (10a, 10b) et au moins une couche interne (11) intercalée entre lesdites au moins deux couches externes (10a, 10b),

lesdites au moins trois couches (10a, 10b, 11) empilées de matériaux à changement de phase étant disposées au moins partiellement entre les deux électrodes (6, 7), au moins une première couche prise parmi lesdites au moins deux couches externes (10a, 10b) et ladite au moins une couche interne (11) étant dans un état amorphe et configurée pour passer au moins localement par pénétration d'un faisceau photonique et/ou ionique (9) dudit état amorphe pour lequel le condensateur présente une première capacité et/ou une première résistance à un état cristallin pour lequel le condensateur présente une deuxième capacité et/ou une deuxième résistance respectivement différentes de la première capacité et de la première résistance, au moins une deuxième couche prise parmi lesdites au moins deux couches externes (10a, 10b) et ladite au moins une couche interne (11) étant dans un état cristallin, le dispositif de protection étant relié électriquement au circuit intégré (1) par au moins une desdites première ou deuxième électrodes (6-7) de sorte que le circuit intégré (1) mesure la résistance et/ou la capacité du condensateur.

2. Puce selon la revendication précédente dans laquelle chacune des premières et deuxième électrodes (6, 7) recouvrent respectivement et entièrement l'une des deux couches externes (10a, 10b).

3. Puce selon la revendication 1 dans laquelle les premières et deuxième électrodes (6, 7) recouvrent partiellement au moins et respectivement une couche externe (10a, 10b) qui lui est associée et dans laquelle au moins l'une parmi les premières et deuxième électrodes (6, 7) recouvrent une partie seulement de la couche externe (10a, 10b) qui lui est associée.

4. Puce selon l'une quelconque des revendications précédentes dans laquelle la deuxième résistance du condensateur est inférieure à la première résistance.

5. Puce selon l'une quelconque des revendications précédentes dans laquelle le circuit intégré (1) est agencé sur une première face parmi une face avant (4) ou une face arrière (5) du substrat (2) et dans lequel le dispositif de protection (3) est agencé sur une deuxième face du substrat (2), différente de la première face sur laquelle le circuit intégré (1) est agencé et choisie parmi la face avant (4) ou la face arrière (5) du substrat (2).

6. Puce selon l'une quelconque des deux revendications précédentes dans laquelle au moins une couche interne (11) est ladite première couche dans un état amorphe et dans laquelle au moins l'une desdites deux couches externes (10a, 10b) est ladite deuxième couche dans un état cristallin.

7. Puce selon l'une quelconque des revendications précédentes comprenant :

- une couche interne (11) formant ladite première couche dans un état amorphe et
- deux couches externes (10a, 10b) dans un état cristallin.

8. Puce selon l'une quelconque des deux revendications précédentes dans laquelle la température de cristallisation de la au moins une couche interne (11) de matériau à changement de phase est supérieure aux températures de cristallisation des couches externes (10a, 10b) de matériau à changement de phase.

9. Puce selon l'une quelconque des trois revendications précédentes dans laquelle les couches externes (10a, 10b) de matériau à changement de phase ont une épaisseur comprise entre 50nm et 200nm et dans laquelle la au moins une couche interne (11) de matériau à changement de phase a une épaisseur de préférence comprise entre 5 et 30nm.

10. Puce selon l'une quelconque des revendications précédentes dans laquelle le circuit de protection (3) est relié électriquement au circuit intégré (1) par une interconnexion enterrée.

11. Puce selon l'une quelconque des revendications précédentes dans laquelle le circuit intégré (1) agencé sur une face parmi une face avant (4) ou une face arrière (5) du substrat (2) et dans lequel le dispositif de protection (3) s'étend sur une surface du substrat (2) au moins équivalente à la surface sur laquelle s'étend le circuit intégré (1).

12. Puce selon l'une quelconque des revendications précédentes dans laquelle le au moins un condensateur comprend au moins une tranchée (12) formée dans l'épaisseur du substrat (2) et dans laquelle la tranchée (12) présente une largeur de préférence comprise entre 500nm et 1$\mu$m.

13. Puce selon l'une quelconque des revendications précédentes dans laquelle le dispositif de protection

(3) comprend une pluralité de condensateurs connectés en série.

14. Procédé de fabrication d'une puce électronique selon l'une quelconque des revendications précédentes comprenant au moins les étapes suivantes de :

- formation d'un circuit intégré (1) au niveau d'une face d'un substrat (2) choisie parmi la face avant (4) ou la face arrière (5) ;
- formation d'au moins un condensateur au moins partiellement au regard du circuit intégré (1) comprenant

  ○ le dépôt d'une première électrode (6),
  ○ la formation d'au moins une première couche externe (10a) en matériau à changement de phase, située au moins partiellement au regard de la première électrode (6),
  ○ la formation d'au moins une couche interne (11) en matériau à changement de phase, configurée pour passer au moins localement d'un état amorphe à un état cristallin par pénétration d'un faisceau photonique et/ou ionique (9), le condensateur présentant dans l'état amorphe de l'au moins une couche interne (11) une première capacité et/ou une première résistance et le condensateur présentant dans l'état cristallin de l'au moins une couche interne (11) une deuxième capacité et/ou une deuxième résistance respectivement différentes de la première capacité et de la première résistance,
  ○ la formation d'au moins une deuxième couche externe (10b) en matériau à changement de phase, au moins l'une parmi ladite première (10a) et ladite deuxième (10b) couches externes étant dans un état cristallin;
  ○ et le dépôt d'une deuxième électrode (7) au moins partiellement en regard de la deuxième couche externe (10b) ;

- connexion électrique (13) du circuit de protection (3) au circuit intégré (1).

15. Procédé de fabrication selon la revendication précédente dans lequel l'étape de formation de l'au moins une première couche externe (10a) ou l'étape de formation de l'au moins une deuxième couche externe (10b) comprend le dépôt d'une couche de matériau à changement de phase dans un état amorphe et comprend ensuite une étape configurée de sorte à faire passer le matériau à changement de phase de ladite au moins une couche externe (10a, 10b) de l'état amorphe à un état cristallin.

**Patentansprüche**

1. Elektronischer Chip, der eine integrierte Schaltung (1), die auf einem Substrat (2) eingerichtet ist, und eine Schutzvorrichtung (3) umfasst, die mindestens teilweise der integrierten Schaltung (1) gegenüberliegend eingerichtet ist, wobei der elektronische Chip derart ist, dass die Schutzvorrichtung (3) mindestens einen Kondensator umfasst, welcher umfasst:

   - eine erste Elektrode (6),
   - eine zweite Elektrode (7),
   - und mindestens drei gestapelte Schichten (10a, 10b, 11) aus Phasenwechselmaterialien, die mindestens zwei äußere Schichten (10a, 10b) und mindestens eine innere Schicht (11) definieren, welche zwischen den mindestens zwei äußeren Schichten (10a, 10b) eingefügt ist,

   wobei die mindestens drei gestapelten Phasenwechselmaterial-Schichten (10a, 10b, 11) mindestens teilweise zwischen den zwei Elektroden (6, 7) angeordnet sind, wobei sich mindestens eine erste Schicht aus den mindestens zwei äußeren Schichten (10a, 10b) und der mindestens einen inneren Schicht (11) in einem amorphen Zustand befindet und dafür konfiguriert ist, durch Eindringen eines Photonen- und/oder Ionenstrahls (9) mindestens örtlich aus dem amorphen Zustand, bei dem der Kondensator eine erste Kapazität und/oder einen ersten Widerstand aufweist, in einen kristallinen Zustand überzugehen, bei dem der Kondensator eine zweite Kapazität und/oder einen zweiten Widerstand aufweist, die sich jeweils von der ersten Kapazität und dem ersten Widerstand unterscheiden, wobei sich mindestens eine zweite Schicht aus den mindestens zwei äußeren Schichten (10a, 10b) und der mindestens einen inneren Schicht (11) in einem kristallinen Zustand befindet, wobei die Schutzvorrichtung durch mindestens eine der ersten oder zweiten Elektrode (6-7) elektrisch so mit der integrierten Schaltung (1) verbunden ist, dass die integrierte Schaltung (1) den Widerstand und/oder die Kapazität des Kondensators misst.

2. Chip nach dem vorstehenden Anspruch, wobei jede der ersten und zweiten Elektrode (6, 7) jeweils und vollständig eine der zwei äußeren Schichten (10a, 10b) bedecken.

3. Chip nach Anspruch 1, wobei die ersten und zweite Elektrode (6, 7) jeweils und mindestens teilweise eine äußere Schicht (10a, 10b) bedecken, die ihr zugeordnet ist, und wobei mindestens eine aus den ersten und zweiten Elektrode (6, 7) nur einen Teil der äußeren Schicht (10a, 10b) bedecken, die ihr zugeordnet ist.

**4.** Chip nach einem der vorstehenden Ansprüche, wobei der zweite Widerstand des Kondensators kleiner ist als der erste Widerstand.

**5.** Chip nach einem der vorstehenden Ansprüche, wobei die integrierte Schaltung (1) auf einer ersten Seite aus einer Vorderseite (4) oder einer Rückseite (5) des Substrats (2) eingerichtet ist, und wobei die Schutzvorrichtung (3) auf einer zweiten Seite des Substrats (2) eingerichtet ist, die sich von der ersten Seite unterscheidet, auf der die integrierte Schaltung (1) eingerichtet ist, und die aus der Vorderseite (4) oder der Rückseite (5) des Substrats (2) ausgewählt ist.

**6.** Chip nach einem der zwei vorstehenden Ansprüche, wobei mindestens eine innere Schicht (11) die erste Schicht in einem amorphen Zustand ist, und wobei mindestens eine der zwei äußeren Schichten (10a, 10b) die zweite Schicht in einem kristallinen Zustand ist.

**7.** Chip nach einem der vorstehenden Ansprüche, umfassend:

- eine innere Schicht (11), die die erste Schicht in einem amorphen Zustand bildet, und
- zwei äußere Schichten (10a, 10b) in einem kristallinen Zustand.

**8.** Chip nach einem der zwei vorstehenden Ansprüche, wobei die Kristallisationstemperatur der mindestens einen inneren Phasenwechselmaterial-Schicht (11) höher ist als die Kristallisationstemperaturen der äußeren Phasenwechselmaterial-Schichten (10a, 10b).

**9.** Chip nach einem der drei vorstehenden Ansprüche, wobei die äußeren Phasenwechselmaterial-Schichten (10a, 10b) eine Dicke im Bereich zwischen 50 nm und 200 nm aufweisen, und wobei die mindestens eine innere Phasenwechselmaterial-Schicht (11) eine Dicke von vorzugsweise im Bereich zwischen 5 und 30 nm aufweist.

**10.** Chip nach einem der vorstehenden Ansprüche, wobei die Schutzschaltung (3) durch eine vergrabene Verbindung elektrisch mit der integrierten Schaltung (1) verbunden ist.

**11.** Chip nach einem der vorstehenden Ansprüche, wobei die integrierte Schaltung (1) auf einer Seite aus einer Vorderseite (4) oder einer Rückseite (5) des Substrats (2) eingerichtet, und wobei sich die Schutzvorrichtung (3) auf einer Fläche des Substrats (2) erstreckt, die der Fläche, auf der sich die integrierte Schaltung (1) erstreckt, mindestens gleichwertig ist.

**12.** Chip nach einem der vorstehenden Ansprüche, wobei der mindestens eine Kondensator mindestens einen Graben (12) umfasst, der in der Dicke des Substrats (2) gebildet ist, und wobei der Graben (12) eine Breite von vorzugsweise im Bereich zwischen 500 nm und 1 μm aufweist.

**13.** Chip nach einem der vorstehenden Ansprüche, wobei die Schutzvorrichtung (3) eine Vielzahl von Kondensatoren umfasst, die in Reihe geschaltet sind.

**14.** Verfahren zur Herstellung eines elektronischen Chips nach einem der vorstehenden Ansprüche, das mindestens die folgenden Schritte umfasst des:

- Bildens einer integrierten Schaltung (1) im Bereich einer Seite eines Substrats (2), ausgewählt aus der Vorderseite (4) oder der Rückseite (5);
- Bildens mindestens eines Kondensators, der der integrierten Schaltung (1) mindestens teilweise gegenüberliegt, umfassend

   ○ das Abscheiden einer ersten Elektrode (6),
   ○ das Bilden mindestens einer ersten äußeren Schicht (10a) aus Phasenwechselmaterial, die sich mindestens teilweise der ersten Elektrode (6) gegenüberliegend befindet,
   ○ das Bilden mindestens einer inneren Schicht (11) aus Phasenwechselmaterial, die dafür konfiguriert ist, durch Eindringen eines Photonen- und/oder Ionenstrahls (9) mindestens örtlich aus einem amorphen Zustand in einen kristallinen Zustand überzugehen, wobei der Kondensator im amorphen Zustand der mindestens einen inneren Schicht (11) eine erste Kapazität und/oder einen ersten Widerstand aufweist, und wobei der Kondensator im kristallinen Zustand der mindestens einen inneren Schicht (11) eine zweite Kapazität und/oder einen zweiten Widerstand aufweist, die sich jeweils von der ersten Kapazität und dem ersten Widerstand unterscheiden,
   ○ das Bilden von mindestens einer zweiten äußeren Schicht (10b) aus Phasenwechselmaterial, wobei sich mindestens eine aus der ersten (10a) und der zweiten (10b) äußeren Schicht in einem kristallinen Zustand befindet;
   ○ und das Abscheiden einer zweiten Elektrode (7), die der zweiten äußeren Schicht (10b) mindestens teilweise gegenüberliegt;

- elektrischen Verbindens (13) der Schutzschaltung (3) mit der integrierten Schaltung (1).

**15.** Herstellungsverfahren nach dem vorstehenden Anspruch, wobei der Schritt des Bildens der mindestens einen ersten äußeren Schicht (10a) oder der Schritt des Bildens der mindestens einen zweiten äußeren Schicht (10b) das Abscheiden einer Schicht aus Phasenwechselmaterial in einem amorphen Zustand umfasst, und anschließend einen Schritt umfasst, der so konfiguriert ist, dass er das Phasenwechselmaterial der mindestens einen äußeren Schicht (10a, 10b) aus dem amorphen Zustand in einen kristallinen Zustand übergehen lässt.

## Claims

**1.** Electronic chip comprising an integrated circuit (1) arranged on a substrate (2) and a protective device (3) arranged at least partially facing the integrated circuit (1), the electronic chip being such that the protective device (3) comprises at least one condenser comprising:

- a first electrode (6),
- a second electrode (7),
- and at least three stacked layers (10a, 10b, 11) of phase change materials, defining at least two outer layers (10a, 10b) and at least one inner layer (11) inserted between said at least two outer layers (10a, 10b),

said at least three stacked layers (10a, 10b, 11) of phase change materials being arranged at least partially between the two electrodes (6, 7), at least one first layer taken from among said at least two outer layers (10a, 10b) and said at least one inner layer (11) being in an amorphous state and configured to pass at least locally by penetrating a photonic and/or ionic beam (9) from said amorphous state for which the condenser has a first capacity and/or a first resistance to a crystalline state for which the condenser has a second capacity and/or a second resistance respectively different from the first capacity and from the first resistance, at least one second layer taken from among said at least two outer layers (10a, 10b) and said at least one inner layer (11) being in a crystalline state, the protective device being electrically connected to the integrated circuit (1) by at least one of said first or second electrodes (6-7) such that the integrated circuit (1) measures the resistance and/or capacity of the condenser.

**2.** Chip according to the preceding claim, wherein each of the first and second electrodes (6, 7) cover respectively and fully one of the two outer layers (10a, 10b).

**3.** Chip according to claim 1, wherein the first and second electrodes (6, 7) cover partially at least and respectively one outer layer (10a, 10b) which is associated with it, and wherein at least one from among the first and second electrodes (6, 7) cover only one portion of the outer layer (10a, 10b) which is associated with it.

**4.** Chip according to any one of the preceding claims, wherein the second resistance of the condenser is less than the first resistance.

**5.** Chip according to any one of the preceding claims, wherein the integrated circuit (1) is arranged on a first face from among a front face (4) or a rear face (5) of the substrate (2), and wherein the protective device (3) is arranged on a second face of the substrate (2), different from the first face on which the integrated circuit (1) is arranged and selected from among the front face (4) or the rear face (5) of the substrate (2).

**6.** Chip according to any one of the two preceding claims, wherein at least one inner layer (11) is said first layer in an amorphous state, and wherein at least one of said two outer layers (10a, 10b) is said second layer in a crystalline state.

**7.** Chip according to any one of the preceding claims comprising:

- an inner layer (11) forming said first layer in an amorphous state, and
- two outer layers (10a, 10b) in a crystalline state.

**8.** Chip according to any one of the two preceding claims, wherein the crystallisation temperature of the at least one inner layer (11) of phase change material is greater than the crystallisation temperatures of the outer layers (10a, 10b) of phase change material.

**9.** Chip according to any one of the three preceding claims, wherein the outer layers (10a, 10b) of phase change material have a thickness of between 50nm and 200nm, and wherein the at least one inner layer (11) of phase change material has a thickness, preferably of between 5nm and 30nm.

**10.** Chip according to any one of the preceding claims, wherein the protective circuit (3) is electrically connected to the integrated circuit (1) by a buried interconnection.

**11.** Chip according to any one of the preceding claims, wherein the integrated circuit (1) arranged on a face from among a front face (4) or a rear face (5) of the substrate (2), and wherein the protective device (3) extends over a surface of the substrate (2) at least equivalent to the surface over which the integrated circuit (1) extends.

**12.** Chip according to any one of the preceding claims, wherein the at least one condenser comprises at least one trench (12) formed in the thickness of the substrate (2), and wherein the trench (12) has a width, preferably of between 500nm and 1μm.

**13.** Chip according to any one of the preceding claims, wherein the protective device (3) comprises a plurality of condensers connected in series.

**14.** Method for manufacturing an electronic chip according to any one of the preceding claims comprising at least the following steps of:

- forming an integrated circuit (1) at the level of a face of a substrate (2) selected from among the front face (4) or the rear face (5);
- forming at least one condenser at least partially facing the integrated circuit (1) comprising

  ∘ the deposition of a first electrode (6),
  ∘ the formation of at least one first outer layer (10a) made of phase change material, situated at least partially facing the first electrode (6),
  ∘ the formation of at least one inner layer (11) made of phase change material, configured to pass at least locally from an amorphous state to a crystalline state by penetrating a photonic and/or ionic beam (9), the condenser having, in the amorphous state of at least one inner layer (11), a first capacity and/or a first resistance and the condenser having, in the crystalline state of at least one inner layer (11), a second capacity and/or a second resistance respectively different from the first capacity and from the first resistance,
  ∘ the formation of at least one second outer layer (10b) made of phase change material, at least one from among said first (10a) and said second (10b) outer layers being in a crystalline state,
  ∘ and the deposition of a second electrode (7) at least partially facing the second outer layer (10b);

- electrical connection (13) from the protective circuit (3) to the integrated circuit (1).

**15.** Manufacturing method according to the preceding claim, wherein the step of forming the at least one first outer layer (10a) or the step of forming the at least one second outer layer (10b) comprises the deposition of a layer of phase change material in an amorphous state and then comprises a step configured to as to make the phase change material of said at least one outer layer (10a, 10b) pass from the amorphous state to a crystalline state.

**FIG. 1**

**FIG. 2**

**FIG. 3**

**FIG. 4**

**FIG. 5**

Epaisseur (nm) couche externe 10a

Epaisseur (nm) couche interne

## FIG. 6

Impulsion laser          Récupération

**FIG. 7**

**FIG. 8**

**FIG. 9**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2010026313 A1
- US 8525169 B1
- US 2010301896 A1